# FASCICULE DE BREVET EUROPEEN

(11) **EP 0 493 149 B1**
(45) Date de publication et mention de la délivrance du brevet: **09.03.1994**
(21) Numéro de dépôt: 91403221.4
(22) Date de dépôt: 27.11.1991
(51) Int. Cl.: H03H 11/26

(54) **Dispositif de retard réglable**
Einstellbare Verzögerungsanordnung
Controllable delay device

(30) Priorité: 27.12.1990 FR 9016340
(43) Date de publication de la demande: 01.07.1992
(73) Titulaire: BULL S.A., 92800 Puteaux (FR)
(72) Inventeur: Marbot, Roland, F-75116 Paris (FR)
(74) Mandataire: Denis, Hervé

(56) Documents cités:
- EP-A- 0 239 696
- EP-A- 0 315 385
- US-A- 4 422 052

## Description

L'invention a pour objet un dispositif de retard réglable. Elle s'applique notamment aux systèmes de transmission de données numériques à très haut débit, à plus de 1 gigabit par seconde par exemple.

Les dispositifs de retard actuels sont couramment faits de circuits RC. Le réglage du retard se fait par variation de la valeur de la résistance et/ou de la capacité. Dans un circuit intégré à transistors à effet de champ, de type MOS (Métal Oxyde Semiconducteur) par exemple, la résistance et la capacité sont ordinairement constituées par des transistors.

L'inconvénient de tels dispositifs à retard est la courbe de forme exponentielle de la variation du retard par rapport à la variation des valeurs de R et de C. La linéarité du réglage du retard nécessite donc des produits RC de fortes valeurs, incompatibles avec des temps de retard très courts. D'autre part, les circuits RC doivent être insérés entre des circuits tampons d'entrée et de sortie rendant les circuits extérieurs insensibles aux variations de R et de C. En outre, la technologie de fabrication des transistors à effet de champ produit de fortes dérives dans les caractéristiques des transistors de circuits intégrés différents. Ces dérives s'opposent à la fiabilité et à la finesse recherchées du réglage du retard.

L'invention présente un dispositif à retard réglable offrant les avantages de ne pas présenter une courbe de variation logarithmique, de produire des retards très courts, de régler la valeur des retards de façon fine et fiable, et d'avoir une structure simple, bien adaptée à son intégration dans des circuits intégrés de type BiCMOS (Bipolar/Complementary MOS) et ne nécessitant pas de circuits tampons d'entrée et de sortie.

Un dispositif de retard réglable conforme à l'invention est caractérisé en ce qu'il comprend un amplificateur différentiel dont la source de courant et les deux résistances de charge sont associées à des moyens de réglage agissant de façon que le produit du courant par chacune des résistances soit constant.

Les caractéristiques et avantages de l'invention ressortent clairement de la description qui suit, donnée à titre d'exemple et faite en référence aux dessins annexés.

Dans les dessins :
- la figure 1 est une vue schématique du circuit d'un mode de réalisation préféré d'un dispositif de retard réglable conforme à l'invention ;
- la figure 2 est un graphe illustrant la variation du temps de retard du dispositif représenté sur la figure 1 ;
- la figure 3 est une vue synoptique d'un mode de réalisation d'un dispositif de retard conforme à l'invention, présentant un retard réglable sur une large gamme de variation ; et
- la figure 4 est une vue synoptique d'une variante de réalisation du dispositif de retard représenté sur la figure 3.

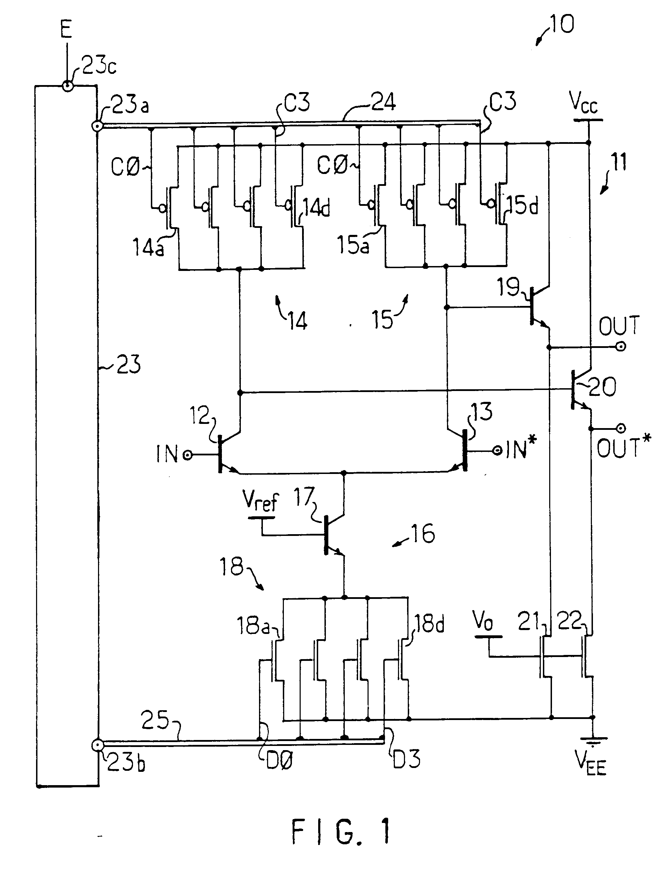

Sur la figure 1, le dispositif de retard 10 conforme à l'invention est fait à partir d'une porte ECL (Emitter-Coupled Logic) 11. Il est alimenté en tension entre les potentiels V_{CC} et V_{EE}, valant respectivement + 5 Volts et la masse par exemple. Les deux transistors bipolaires d'entrée 12 et 13 de la porte 11 reçoivent respectivement sur leurs bases le signal d'entrée direct IN et le signal d'entrée inversé IN*. Leurs collecteurs sont reliés au potentiel V_{CC} par l'intermédiaire de charges résistives respectives 14 et 15. Leurs émetteurs sont réunis et reliés au potentiel V_{EE} par une source de courant 16 faite d'un transistor bipolaire 17 et d'une charge résistive 18. Le transistor 17 a son collecteur connecté aux émetteurs des transistors 12 et 13, son émetteur connecté à la charge résistive 18 et sa base recevant un potentiel de référence V_{REF}. Les collecteurs des transistors 12 et 13 sont aussi connectés aux bases de deux transistors bipolaires 19 et 20 formant deux amplificateurs de sortie à émetteur suiveur. Leurs collecteurs sont connectés au potentiel V_{CC} et leurs émetteurs sont reliés au potentiel V_{EE} par des résistances respectives 21 et 22 et délivrent les signaux de sortie complémentaires OUT et OUT*. De manière classique, les résistances sont faites de transistors respectifs à effet de champ, de type MOS par exemple. La valeur de la résistance d'un tel transistor est prédéterminée à la fabrication notamment par la largeur électrique de sa grille et, en pratique, par la tension grille-source nécessaire pour faire conduire le transistor.

Selon l'invention, la porte ECL 11 comporte un circuit de réglage 23 du courant de polarisation I produit par la source 16 et de la valeur R de chacune des charges résistives 14 et 15, de façon que leur produit RI soit constant. Dans l'exemple illustré, le réglage commandé par le circuit 23 n'est pas continu. Les charges résistives 14 et 15 sont faites chacune de quatre résistances 14a-14d et 15a-15d, et la charge 18 de la source de courant 16 se compose de quatre résistances 18a-18d. Toutes les résistances dans chacune des charges 14, 15 et 18 sont formées par des transistors MOS ayant leurs trajets drain-source en parallèle. Les transistors dans les charges 14 et 15 sont de type PMOS et leurs grilles sont réunies à un bus 24 connecté à une borne de commande 23a du circuit de réglage 23. Les transistors dans la charge 18 sont de type NMOS et leurs grilles sont réunies à un bus 25 connecté à une autre borne de commande 23b du circuit 23. Les bornes de commande 23a et 23b délivrent respectivement deux signaux de commande C et D pouvant prendre quatre valeurs distinctes de potentiel C0-C3 et D0-D3 en réponse à un signal de pilotage E appliqué sur une borne d'entrée 23c du circuit de réglage 23.

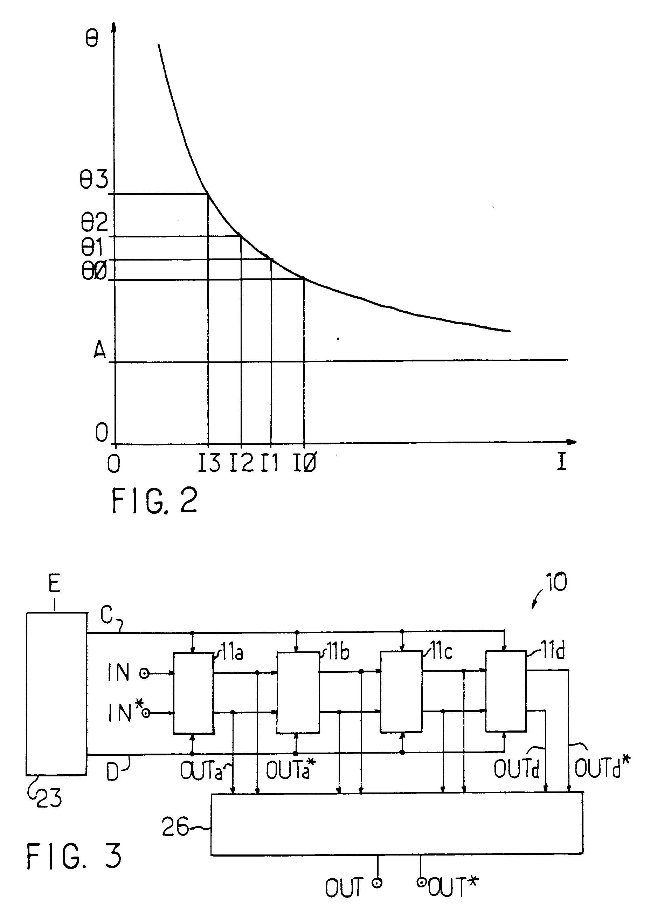

Le fonctionnement du dispositif de retard réglable 10 illustré dans la figure 1 va être fait en référence au graphe de la figure 2. Le graphe représente les variations du retard ⊖ des signaux de sortie complémentaires OUT et OUT* en fonction des variations du courant I telles que RI soit constant. La variation du courant de polarisation est choisie sensiblement linéaire. Dans ces conditions, la courbe est une hyperbole du type ⊖ = A + B/I, où A est l'ordonnée de l'asymptote horizontale (non représentée) et B un coefficient prédéterminé, égal à 1 dans l'exemple illustré. Les quatre valeurs I0-I3 de I sont déterminées par les quatre valeurs respectives D0-D3 du signal de commande D de la conduction des transistors 18a-18d correspondants. Aux quatre valeurs D0-D3 correspondent les quatre valeurs de C0-C3 commandant la conduction des transistors respectifs 14a-14d et 15a-15d fonctionnant en résistances. Dans l'exemple illustré, la valeur I0 correspondant aux valeurs C0 et D0 est obtenue par la conduction des transistors 14a, 15a et 18a.

Les quatre valeurs I0-I3 sont de préférence choisies dans une partie sensiblement médiane et linéaire de la courbe, de façon que les quatre valeurs de retard ⊖1-⊖3 en résultant soient sensiblement équidistantes les unes des autres et soient distinctes entre elles d'une valeur désirée. Il ressort en effet du graphe que des valeurs de I trop dispersées produiraient des variations fortement non linéaires de ⊖, que des valeurs de I groupées dans la partie asymptotique horizontale produiraient des valeurs de ⊖ peu différenciables entre elles et que dans la partie asymptotique verticale les valeurs désirées de ⊖ seraient obtenues pour de trop faibles variations de I, compte tenu des dérives technologiques.

Le dispositif de retard 10 conforme à l'invention présente plusieurs avantages. La présence de transistors bipolaires comme éléments actifs dans l'amplificateur différentiel 11 confère une fiabilité et une homogénéité des temps de retard ⊖. Elle remédie aux problèmes de non homogénéité qui se présenteraient dans un amplificateur différentiel de type CMOS (Complementary MOS) à cause de la différence notable des retards dans les transistors NMOS et PMOS par rapport aux temps de retard très courts ⊖ de la traversée du dispositif de retard 10, de l'ordre de 250 ps dans l'exemple illustré. Un autre avantage réside dans l'utilisation de signaux d'entrée complémentaires IN et IN* sur les bases des transistors 12 et 13 de l'amplificateur différentiel de type ECL 11. En effet, l'emploi du signal d'entrée IN et d'une tension de référence poserait un problème de centrage du front du signal IN sur la tension de référence à cause de la dispersion des caractéristiques des composants entre différents circuits intégrés. Un décalage du centrage produirait des retards ⊖ non homogènes. Au contraire, dans l'exemple illustré, le centrage se fait sur le point de croisement des fronts des signaux d'entrée complémentaires, qui compense toute dérive et assure un temps de retard stable.

Le fonctionnement du circuit de réglage 23 consiste donc dans ce cas à convertir le signal de pilotage E en deux signaux de commande C et D ayant chacun quatre valeurs correspondantes à un produit RI sensiblement constant. Un tel convertisseur est bien connu de l'homme du métier et n'a donc pas besoin d'être décrit.

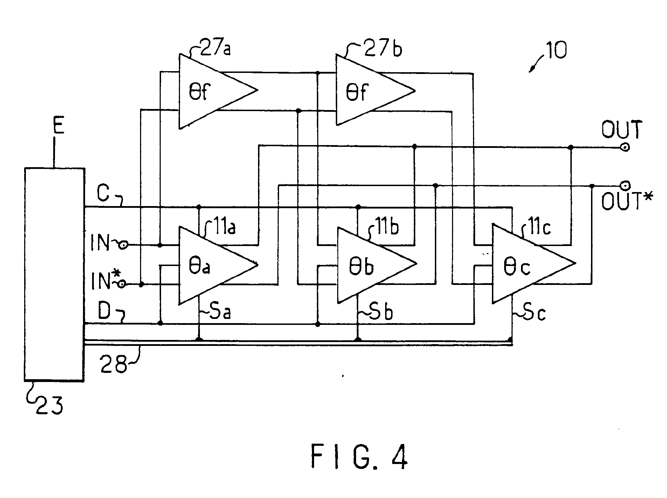

De nombreuses variantes peuvent être apportées à l'exemple de réalisation illustré. Il est clair notamment qu'au lieu de la porte ECL illustrée, un simple amplificateur différentiel à transistors bipolaires ou à effet de champ pourrait dans certains cas suffire. L'avantage d'une porte ECL réside principalement dans ses retards très courts et dans ses performances aux hautes fréquences, dues à la non saturation de ses transistors 12 et 13 et à la faible variation de ses tensions de sortie (voltage swing) en fonction de la fréquence. Il ressort aussi de la description qui précède qu'un circuit de réglage 23 plus perfectionné et une courbe ⊖ = f (I) mieux adaptée pourraient faire varier les retards ⊖ de façon plus dense, plus étalée et plus linéaire. Par exemple, un grand nombre de résistances dans les charges 14, 15 et 18 permettrait un réglage très fin du retard ⊖. D'une manière générale, la source de courant dans la porte ECL 11 ou dans un simple amplificateur différentiel de substitution pourrait n'inclure que la résistance 18. En variante, les signaux de commande du courant I pourraient seulement agir sur la tension de commande de conduction du transistor 17, c'est-à-dire sur la base de ce transistor. On a vu aussi plus haut que la porte ECL, ou l'amplificateur différentiel de substitution, pourrait ne recevoir que le signal d'entrée direct IN, l'autre borne d'entrée étant appliquée à un potentiel fixe prédéterminé. Il est aussi possible pour l'homme du métier de faire varier le retard ⊖ de façon continue. Il serait aussi possible de faire varier le courant de polarisation selon une fonction d'ordre supérieur, 2 par exemple, de façon à obtenir une courbe du type ⊖ = A + B/I² présentant des branches plus linéaires mais faisant varier fortement les retards ⊖. De plus, si les temps de retard désirés vont au-delà des possibilités d'un simple dispositif de retard 10, il est aussi possible d'assembler plusieurs dispositifs 10 de la façon illustrée sur les figures 3 et 4.

La figure 3 représente de façon synoptique la structure d'une variante de réalisation du dispositif de retard 10 conforme à l'invention, incorporant quatre portes ECL 11a-11d montées en cascade. Les portes 11a-11d sont commandées par le même circuit de réglage 23 pour retarder successivement les signaux d'entrée IN et IN*. Leurs signaux de sortie OUTa-OUTd et OUTa*-OUTd* sont aussi appliqués sur les entrées respectives d'un multiplexeur 26, qui délivre les signaux de sortie complémentaires OUT et OUT* du dispositif de retard 10. Sachant que le dispositif 10 peut apporter quatre valeurs de retard, dont un retard maximum de l'ordre de 250 ps , il est possible d'obtenir du dispositif de retard 10 seize valeurs de retard ⊖ s'étalant jusqu'à un retard de l'ordre de 1 ns, qui correspond à une période de transmission d'un bit au débit d'1 gigabit par seconde. L'exemple d'assemblage de la figure 3 suffit à l'homme du métier pour en concevoir d'autres, plus ou moins performants selon les cas, tel que par exemple celui représenté sur la figure 4.

Dans l'exemple illustré de façon synoptique dans la figure 4, le dispositif de retard 10 se compose de trois portes ECL 11a-11c identiques à la porte 11 dans la figure 1 et de deux portes ECL 27a, 27b du même type que les portes 11a-11c mais n'incorporant qu'une résistance de charge correspondante 14, 15 et 18 pour produire un retard fixe ⊖f. Les portes 11a-11c peuvent se partager les mêmes résistances de charge 14a-14d et 15a-15d ainsi que les mêmes amplificateurs de sortie 19-22 et les mêmes sorties. Elles sont commandées par les mêmes signaux de commande C et D issus d'un même circuit de réglage 23. Le circuit 23 a seulement en plus un sélecteur (non représenté) fournissant à un bus 28 des signaux de sélection Sa-Sc aux portes respectives 11a-11c. Les portes 11a et 27a reçoivent les signaux d'entrée IN et IN*, et les portes 11b, 11c reçoivent respectivement les signaux de sortie des portes 27a et 27b. Les signaux de sortie de la porte 27a sont aussi appliqués sur les bornes d'entrée de la porte 27b. En fonctionnement, la sélection de seulement la porte 11a fournit un retard ⊖a identique au retard ⊖de la porte 11 dans la figure 1. La sélection seulement de la porte 11b fournit le retard ⊖b = ⊖f + ⊖. La sélection seulement de la porte 11c fournit le retard ⊖c = 2⊖f + ⊖. La courbe en résultant peut être linéaire si les gammes de variation ⊖a, ⊖b et ⊖c sont associées sans chevauchement. Pour éviter cependant toute oscillation du sélecteur autour des points de jonction de deux retards fournis sucessivement par les portes 11a et 11b par exemple, il est préférable de faire chevaucher les différentes gammes pour avoir une courbe en forme de dents de scie et une variation générale sensiblement linéaire sans risque d'oscillation. En conclusion, le principe de ce dispositif de retard consiste à ajouter sélectivement au moins un retard fixe ⊖f au retard variable produit par au moins un amplificateur différentiel ou une porte ECL 11. D'une manière générale les retards fixes ⊖f peuvent être égaux ou différents entre eux.

## Revendications

1. Dispositif de retard réglable (10), caractérisé en ce qu'il comprend au moins un amplificateur différentiel (11) dont la source de courant (16) et les deux résistances de charge (14, 15) sont associées à des moyens de réglage (23, 14a-14d, 15a-15d, 18a-18d) agissant de façon que le produit du courant par chacune desdites résistances soit constant.

2. Dispositif selon la revendication 1, caractérisé en ce que la source de courant incluant une résistance de charge (18), les moyens de réglage agissent sur cette résistance pour faire varier le courant.

3. Dispositif selon la revendication 1 ou 2, caractérisé en ce que les moyens de réglage comprennent un circuit de réglage (23) et, dans chacune des résistances de charge (14, 15, 18), une pluralité de transistors MOS ayant leurs trajets drain-source en parallèle et leurs grilles réunies à une borne de commande du circuit de réglage.

4. Dispositif selon la revendication 1, caractérisé en ce que la source de courant incluant un transistor (17), les moyens de réglage agissent sur la tension de commande de conduction de ce transistor.

5. Dispositif selon l'une des revendications 1 à 4, caractérisé en ce que la variation du courant de polarisation est sensiblement linéaire.

6. Dispositif selon l'une des revendications 1 à 4, caractérisé en ce que la variation du courant de polarisation est une fonction carrée (I²) ou d'ordre supérieur.

7. Dispositif selon l'une des revendications 1 à 6, caractérisé en ce que les deux entrées de l'amplificateur différentiel reçoivent les versions complémentaires d'un signal d'entrée (IN).

8. Dispositif selon l'une des revendications 1 à 7, caractérisé en ce que l'amplificateur différentiel forme une porte ECL.

9. Dispositif selon l'une des revendications 1 à 8, caractérisé en ce qu'il comporte plusieurs amplificateurs différentiels (11a-11d) dont les sorties respectives sont appliquées à un multiplexeur (25).

10. Dispositif selon l'une des revendications 1 à 8, caractérisé en ce que le retard variable produit par au moins ledit amplificateur différentiel est sélectivement ajouté à au moins un retard fixe ( ⊖f - figure 4).

## Claims

1. An adjustable delay service (10), characterised in that it comprises at least one differential amplifier (11), of which the current source (16) and the two load resistors (14, 15) are associated with adjustment means (23, 14a-14d, 15a-15d, 18a-18d) acting in such a manner that the product of the current through each of said resistors is constant.

2. A device according to claim 1, characterised in that the current source comprises a load resistor (18), the adjustment means acting upon said resistor to cause the current to vary.

3. A device according to claim 1 or 2, characterised in that the adjustment means comprises an adjustment circuit (23) and, in each of the load resistors (14, 15, 18), a plurality of MOS transistors having their drain-to-source paths in parallel and their gates joined to a control terminal of the adjustment circuit.

4. A device according to claim 1, characterised in that the current source includes a transistor (17), the adjustment means acting upon the conduction control voltage of this transistor.

5. A device according to one of claims 1 to 4, characterised in that the variation of the polarisation current is substantially linear.

6. A device according to one of claims 1 to 4, characterised in that the variation of the polarisation current is a squared function (I²) or a higher order function.

7. A device according to one of claims 1 to 6, characterised in that the two inputs of the differential amplifier receives the complementary versions of an input signal (IN).

8. A device according to one of claims 1 to 7, characterised in that the differential amplifier forms an ECL gate.

9. A device according to one of claims 1 to 8, characterised in that it comprises several differential amplifiers (11a-11d), the respective outputs of which are applied to a multiplexer (26).

10. A device according to one of claims 1 to 8, characterised in that the variable delay produced by said differential amplifier is selectively added to at least one fixed delay (⊖f - figure 4).

## Patentansprüche

1. Einstellbare Verzögerungsanordnung (10), dadurch gekennzeichnet, daß sie wenigstens einen Differenzverstärker (11) aufweist, dessen Stromquelle (16) und dessen zwei Lastwiderstände (14, 15) mit Einstellmitteln (23, 14a-14d, 15a-15d, 18a-18d) verbunden sind, die so wirken, daß das Produkt des Stroms mit jedem der genannten Widerstände konstant ist.

2. Anordnung gemäß Anspruch 1, dadurch gekennzeichnet, daß dann, wenn die Stromquelle einen Lastwiderstand (18) enthält, die Einstellmittel auf diesen Widerstand einwirken, um den Strom zu verändern.

3. Anordnung gemäß Anspruch 1 oder 2, dadurch gekennzeichnet, daß die Einstellmittel eine Einstellschaltung (23) sowie in jedem der Lastwiderstände (14, 15, 18) mehrere MOS-Transistoren aufweisen, deren Drain-Source-Pfade parallel geschaltet sind und deren Gates an einem Steueranschluß der Einstellschaltung zusammengeführt sind.

4. Anordnung gemäß Anspruch 1, dadurch gekennzeichnet, daß dann, wenn die Stromquelle einen Transistor (17) enthält, die Einstellmittel auf die Durchlaßsteuerspannung dieses Transistors einwirken.

5. Anordnung gemäß einem der Ansprüche 1 bis 4, dadurch gekennzeichnet, daß die Veränderung des Vorspannungsstroms im wesentlichen linear ist.

6. Anordnung gemäß einem der Ansprüche 1 bis 4, dadurch gekennzeichnet, daß die Veränderung des Vorspannungsstroms eine quadratische Funktion (I²) oder eine Funktion höherer Ordnung ist.

7. Anordnung gemäß einem der Ansprüche 1 bis 6, dadurch gekennzeichnet, daß die beiden Eingänge des Differenzverstärkers die komplementären Versionen eines Eingangssignals (IN) empfangen.

8. Anordnung gemäß einem der Ansprüche 1 bis 7, dadurch gekennzeichnet, daß der Differenzverstärker ein ECL-Gatter bildet.

9. Anordnung gemäß einem der Ansprüche 1 bis 8, dadurch gekennzeichnet, daß sie mehrere Differenzverstärker (11a-11d) enthält, deren jeweiligen Ausgänge in einen Multiplexierer (25) eingegeben werden.

10. Anordnung gemäß einem der Ansprüche 1 bis 8, dadurch gekennzeichnet, daß die einstellbare Verzögerung, die wenigstens von dem genannten Differenzverstärker erzeugt wird, wahlweise wenigstens einer festen Verzögerung (⊖f - Fig. 4) hinzugefügt wird.
